# EUROPEAN PATENT APPLICATION

(11) **EP 4 796 932 A1**
(43) Date of publication of application: **26.08.2026**
(21) Application number: 26159023.6
(22) Date of filing: 17.02.2026
(51) Int. Cl.: G01R 1/04, G01R 31/385, H01M 10/42, H01M 10/48

(54) **SECONDARY BATTERY TESTING APPARATUS**

(30) Priority: 20.02.2025 KR 20250022332
(71) Applicant: SAMSUNG SDI CO., LTD., Yongin-si, Gyeonggi-do 17084 (KR)
(72) Inventor: Lee, Kang Hee, 16678 Suwon-si, Gyeonggi-do (KR)
(74) Representative: Gulde & Partner

(57) **Abstract**

The present disclosure relates to a secondary battery testing apparatus including a case, a drum rotatably disposed in the case, a cable configured to be wound around the drum and having a detection terminal extending outward from the case, an adjustment member connected to the drum and configured to adjust rotation of the drum, and a measurement member connected to the cable and configured to measure a detection signal transmitted through the cable.

## Description

### BACKGROUND

### 1. Field of the Invention

The present disclosure relates to a secondary battery testing apparatus.

### 2. Discussion of Related Art

Due to the recent proliferation of electronic devices, such as mobile phones, notebook computers, and electric vehicles, the demand for secondary batteries having a relatively high energy density and a relatively high capacity has been rapidly increasing. Accordingly, research and development are actively conducted for improving the performance of a lithium secondary battery.

A lithium secondary battery is a battery including a positive electrode and a negative electrode, both of which including an active material capable of intercalating and deintercalating lithium ions, and an electrolyte solution. The lithium secondary battery generates energy through oxidation/reduction reactions when lithium ions are intercalated/deintercalated at the positive and negative electrodes.

Because an explosion of a lithium secondary battery may not only cause damage to electronic products but also lead to fire, it is of utmost importance to secure the safety of the lithium secondary battery. Accordingly, it is necessary to accurately test voltages, currents, and temperatures of the lithium secondary battery.

This Background section is for the general understanding of the background of the present disclosure, and therefore, it may contain information that does not constitute related (or prior) art.

### SUMMARY

The present disclosure is directed to a secondary battery testing apparatus in which a cable can be readily managed.

According to embodiments of the present disclosure, a secondary battery testing apparatus includes a case, a drum rotatably installed in the case, a cable wound around the drum and having a detection terminal extending outward from the case, an adjustment member that is connected to the drum and adjusts rotation of the drum, and a measurement member that is connected to the cable and measures a detection signal transmitted through the cable.

The drum, rotatably disposed in the case, enables controlled retraction and extension of the cable wound around it. This allows the length of the cable protruding from the case to be adjusted as needed. One advantage of this feature is the targeted reduction of cable clutter or slack, which improves handling safety and facilitates an orderly wiring layout during battery testing.

The cable is configured to be wound around the drum and includes a detection terminal that extends outside the case. A cable refers to an electrical line for transmitting an electrical detection signal, with the detection terminal forming the electrical contact point to the test object. By enabling the cable to be wound on or off the drum, the device becomes adaptable to test objects of varying sizes or arrangements. One advantage lies in the quick and tool-free setup of the testing connection without manually rerouting or replacing cables.

The adjustment member is connected to the drum and is configured to control the drum's rotation. This allows the cable length to be automatically or at least mechanically adjusted. One advantage of this feature is increased operator convenience, as manual winding of the cable is eliminated and the apparatus maintains a defined cable state. Additionally, by precisely controlling the drum's rotation, a consistent cable tension can be maintained, which helps prevent cable damage.

In some embodiments, the secondary battery testing apparatus includes a plurality of drums and a plurality of cables, wherein each of the cables is configured to be wound one-to-one around each of the drums. By providing a dedicated drum for each cable, the apparatus allows individual adjustment and independent management of multiple cables. This modular winding approach ensures that the length of each cable extending from the apparatus can be independently controlled by rotating its corresponding drum. An advantage of this feature is the prevention of cable entanglement, since each cable operates on a separate path. This improves the operational safety and reliability of the testing process. Another advantage is that this design simplifies the handling and organization of multiple cables, especially in environments where many secondary battery cells are tested simultaneously. It allows for scalable testing setups and efficient cable deployment and retraction for each test point. The ability to selectively extend or retract individual cables without affecting others increases flexibility and reduces preparation time during testing procedures.

In some embodiments, the adjustment member includes: a driving motor configured to generate a rotational force; a first power transmission member configured to be rotated by receiving the rotational force from the driving motor; and a second power transmission member configured to receive a rotational force from the first power transmission member and configured to rotate the drum.

This configuration enables motorized control of the drum's rotation, allowing automatic extension and retraction of the cable. An advantage of this setup is that it reduces the need for manual handling, thereby improving usability and operational efficiency, especially in repetitive testing environments. The use of two stages of power transmission allows for torque multiplication or speed reduction through gear ratios, enabling precise and powerful control of the drum movement. This can be especially advantageous when managing heavier or longer cables, as it ensures smooth and controlled winding/unwinding operations without abrupt tension changes that could damage the cable.

In some embodiments, the adjustment member further includes a motor switch connected to the driving motor and configured to control operation of the driving motor.

By including a motor switch, the apparatus enables user-controlled operation of the cable winding and unwinding process. An advantage of this feature is that it allows manual intervention for precise control of the cable length, which increases operational flexibility during test setup or adjustments. The motor switch allows the user to selectively activate the driving motor only when required, thereby reducing unnecessary power consumption and wear on the mechanical components. Moreover, when the switch includes directional control, it enables the same motor to be used for both winding and unwinding the cable, which simplifies the design and reduces component count.

In some embodiments, the first power transmission member includes: a first transmission gear connected to the driving motor; a second transmission gear spaced apart from the driving motor and connected to the first transmission gear; and a first transmission shaft configured to rotate along with the second transmission gear.

This gear-and-shaft configuration allows effective mechanical coupling between the driving motor and subsequent transmission components while enabling control over the gear ratio between motor speed and drum speed. One advantage is that torque can be increased and rotation speed reduced via an appropriate gear ratio, which allows smoother and more controlled drum movement, which is especially beneficial when handling sensitive or heavy-duty cables. The spatial separation between the driving motor and the second gear provides flexibility in component layout within the case, which supports modular design and facilitates maintenance or customization of the apparatus. It also reduces mechanical stress on the motor by distributing loads across intermediate components.

In some embodiments, a gear ratio of the first transmission gear and the second transmission gear may be about 10:1.

In some embodiments, a gear ratio of the first transmission gear and the second transmission gear may be about ranges from 5:1 to 20:1.

In some embodiments, the second power transmission member includes: a third transmission gear configured to rotate along with the first transmission shaft; a fourth transmission gear facing the third transmission gear and configured to move in a first direction engaging the third transmission gear; a second transmission shaft extending from the fourth transmission gear and is connected to the drum; and a trigger member connected to the second transmission shaft and configured to adjust movement of the fourth transmission gear and the second transmission shaft.

This configuration introduces a selectively engageable gear interface between the motor-driven shaft and the drum, allowing the drum to be mechanically coupled or decoupled from the drive system. An advantage of this setup is operational flexibility: the drum can be engaged when active winding or unwinding is needed, and disengaged when the cable length is to remain fixed or manually adjusted. The third transmission gear, being permanently coupled to the first transmission shaft, ensures continuous availability of torque, while the movability of the fourth transmission gear enables controlled engagement. This helps prevent unnecessary wear on the drum and cable during idle periods. The second transmission shaft transmits torque from the fourth gear to the drum, enabling reliable rotation. Since it is mechanically decoupled by default, manual override becomes possible when the drive is inactive. This is particularly advantageous in scenarios where quick manual adjustments are needed without powering the motor.

In some embodiments, the second transmission shaft may pass through a central portion of the drum.

By having the second transmission shaft pass through the central portion of the drum, a direct and mechanically stable connection between the drive mechanism and the drum is achieved. One advantage of this configuration is improved torque transmission efficiency, as the force is applied directly along the rotational axis of the drum, minimizing bending moments and mechanical losses. This axial alignment also ensures smooth and balanced drum rotation, reducing vibration and wear on bearings and adjacent components. It contributes to the mechanical durability of the apparatus and maintains consistent winding and unwinding behavior of the cable.

In some embodiments, a gear ratio of the third transmission gear and the fourth transmission gear may range from 5:1 to 20:1.

In some embodiments, a gear ratio of the third transmission gear and the fourth transmission gear may be about 10:1.

In some embodiments, trigger member includes: a trigger body movably connected to the case in the first direction or in a direction opposite to the first direction and configured to rotatably support the second transmission shaft; and an elastic member connected to the trigger body and configured to press the trigger body in the direction opposite to the first direction.

One advantage of this configuration is that it enables user-controlled, yet self-resetting engagement and disengagement of the gear system. When the user presses the trigger body, the fourth transmission gear engages with the third gear, enabling active drum rotation. When the force is released, the elastic member automatically returns the trigger body-and thus the fourth gear-to its original disengaged position. This ensures that the gear engagement only occurs during active user operation, preventing unintended drum motion when the system is idle. The rotatable support of the second transmission shaft by the trigger body further ensures precise alignment and stable transmission of torque to the drum. This integration reduces the need for separate support structures, thereby saving space and minimizing mechanical complexity.

In some embodiments, an end portion of the trigger body may protrude outward from the case.

In some embodiments, the secondary battery testing apparatus further includes a guide body disposed in the case and configured to rotatably and movably support the second transmission shaft. This configuration ensures that the second transmission shaft, which transfers torque from the fourth gear to the drum, is accurately supported along both its rotational axis and its linear movement direction. An advantage of this feature is improved mechanical stability during engagement and disengagement of the gear system, which enhances the precision of the power transmission. By providing defined linear guidance, the guide body prevents misalignment or tilting of the second transmission shaft during actuation by the trigger member. This reduces wear on both the shaft and the surrounding components, increasing the service life of the apparatus.

In some embodiments, the secondary battery testing apparatus further includes a brake member fixed to the case and configured to selectively restrict rotation of the fourth transmission gear. By including a brake member that acts specifically on the fourth transmission gear, the apparatus can prevent unintended or residual rotation of the drum after disengagement from the drive system. One advantage of this feature is the stabilization of the cable position: once the desired length of cable has been unwound, the brake member ensures that the drum remains stationary, avoiding slack, recoil, or overextension. Another technical effect is improved safety and control. Since the brake is automatically engaged when the fourth gear is moved away from the third gear (i.e., during disengagement), the user does not need to perform any additional action to lock the system. This provides immediate positional security and prevents any drift of the drum caused by inertia or external tension on the cable.

In some embodiments, the brake member includes a stopper engaging the fourth transmission gear when the fourth transmission gear moves in a direction opposite to the first direction.

In some embodiments, the second power transmission member may further include a friction member disposed between the second transmission shaft and the drum.

In some embodiments, the secondary battery testing apparatus may further include a connection member that is provided between the cable and the measurement member and connects the cable to the measurement member.

In some embodiments, the secondary battery testing apparatus further includes a connection member connecting the cable to the measurement member.

In some embodiments, the connection member may include a connection port connected to the measurement member, and a connector connected to the cable and detachably coupled to the connection port.

In some embodiments, the secondary battery testing apparatus further includes an alarm member connected to the cable and configured to detect disconnection of the cable.

In some embodiments, the secondary battery testing apparatus further includes a power supply member configured to supply power to the adjustment member and the measurement member.

In some embodiments, the secondary battery testing apparatus further includes a power alarm member connected to the power supply member and configured to detect a charging state of the power supply member.

### BRIEF DESCRIPTION OF THE DRAWINGS

The drawings illustrate embodiments of the present disclosure, and further describe aspects and features of the present disclosure along with the detailed description of the present disclosure. Thus, the present disclosure should not be construed as being limited to the drawings:
FIG. 1 is a schematic view showing installation of a secondary battery testing apparatus according to embodiments of the present disclosure;
FIG. 2 is a schematic perspective view showing a secondary battery testing apparatus according to embodiments of the present disclosure;
FIG. 3 is a schematic front cross-sectional view showing the secondary battery testing apparatus according to embodiments of the present disclosure;
FIG. 4 is a schematic side cross-sectional view showing the secondary battery testing apparatus according to embodiments of the present disclosure;
FIG. 5 is a schematic block diagram showing the secondary battery testing apparatus according to embodiments of the present disclosure;
FIG. 6 is a schematic enlarged view showing a second power transmitting member according to embodiments of the present disclosure;
FIG. 7 is a schematic view showing an unwinding operation of a cable according to embodiments of the present disclosure;
FIG. 8 is a schematic view showing an unwinding operation of a cable according to embodiments of the present disclosure;
FIG. 9 is a schematic view showing an unwinding operation of a cable according to embodiments of the present disclosure;
FIG. 10 is a schematic view showing a winding operation of the cable according to embodiments of the present disclosure;
FIG. 11 is a schematic view showing a winding operation of the cable according to embodiments of the present disclosure; and
FIG. 12 is a schematic enlarged view showing a power alarm member according to embodiments of the present disclosure.

### DETAILED DESCRIPTION

Herein, some embodiments of the present disclosure will be described, in further detail, with reference to the accompanying drawings. The terms or words used in this specification and claims should not be construed as being limited to the usual or dictionary meaning and should be interpreted as meaning and concept consistent with the technical idea of the present disclosure based on the principle that the inventor can be his/her own lexicographer to appropriately define the concept of the term.

The embodiments described in this specification and the configurations shown in the drawings are provided as some example embodiments of the present disclosure and do not represent all of the technical ideas, aspects, and features of the present disclosure. Accordingly, it is to be understood that there may be various equivalents and modifications that may replace or modify the embodiments described herein at the time of filing this application.

It is to be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same or like elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B, and C," "at least one of A, B, or C," "at least one selected from a group of A, B, and C," or "at least one selected from among A, B, and C" are used to designate a list of elements A, B, and C, the phrase may refer to any and all suitable combinations or a subset of A, B, and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It is to be understood that, although the terms "first," "second," "third," etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It is to be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (e.g., rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It is to be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

References to two compared elements, features, etc. as being "the same" may mean that they are "substantially the same." Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

When an arbitrary element is referred to as being arranged (or located or positioned) on the "above (or below)" or "on (or under)" a component, it may mean that the arbitrary element is placed in contact with the upper (or lower) surface of the component and may also mean that another component may be interposed between the component and any arbitrary element arranged (or located or positioned) on (or under) the component.

In addition, it is to be understood that when an element is referred to as being "coupled," "linked," or "connected" to another element, the elements may be directly "coupled," "linked," or "connected" to each other, or one or more intervening elements may be present therebetween, through which the element may be "coupled," "linked," or "connected" to another element. In addition, when a part is referred to as being "electrically coupled" to another part, the part may be directly electrically connected to another part or one or more intervening parts may be present therebetween such that the part and the another part are indirectly electrically connected to each other.

Throughout the specification, when "A and/or B" is stated, it means A, B, or A and B, unless otherwise stated. That is, "and/or" includes any or all combinations of a plurality of items enumerated. When "C to D" is stated, it means C or more and D or less, unless otherwise specified.

The terms used in the present specification are for describing embodiments of the present disclosure and are not intended to limit the present disclosure.

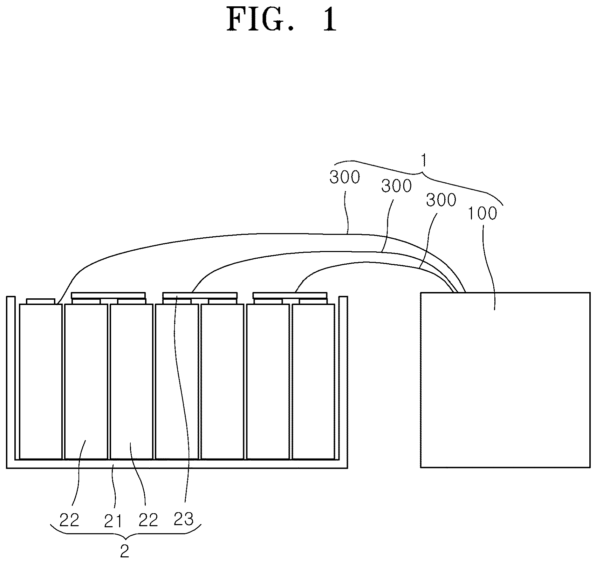

FIG. 1 is a schematic view showing installation of a secondary battery testing apparatus.

Referring to FIG. 1, a secondary battery testing apparatus 1 may perform testing a voltage or temperature of a secondary battery 22 during charging and discharging testing of a battery module 2. The battery module 2 may include a housing 21 and a plurality of secondary batteries 22 accommodated in the housing 21.

The secondary battery 22 may serve as a unit structure that stores and supplies power in and to the battery module 2. The secondary battery 22 may be any type of lithium ion secondary battery that can perform charging and discharging, including an electrode assembly, a can that accommodates the electrode assembly, and positive and negative electrode terminals connected to the electrode assembly. The secondary battery 22 may be a prismatic battery, a polymer battery, or a cylindrical battery. The plurality of secondary batteries 22 may be connected in series or in parallel via a busbar 23.

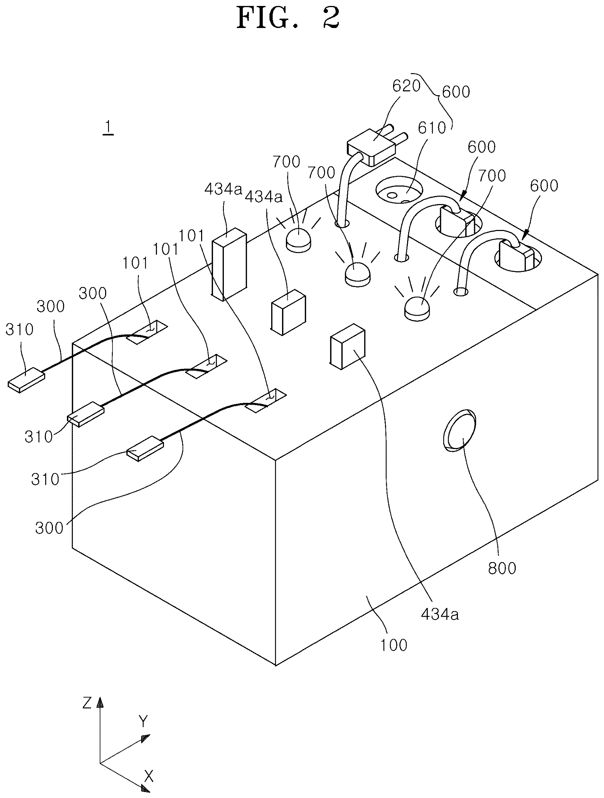

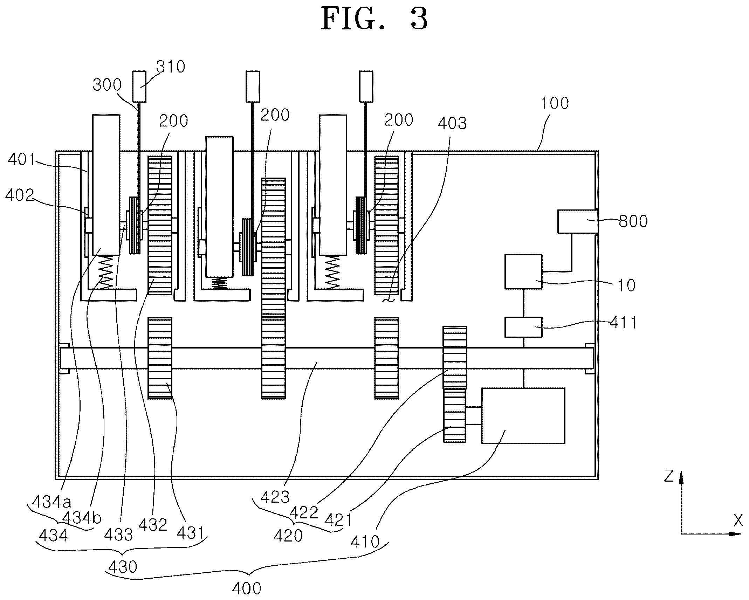

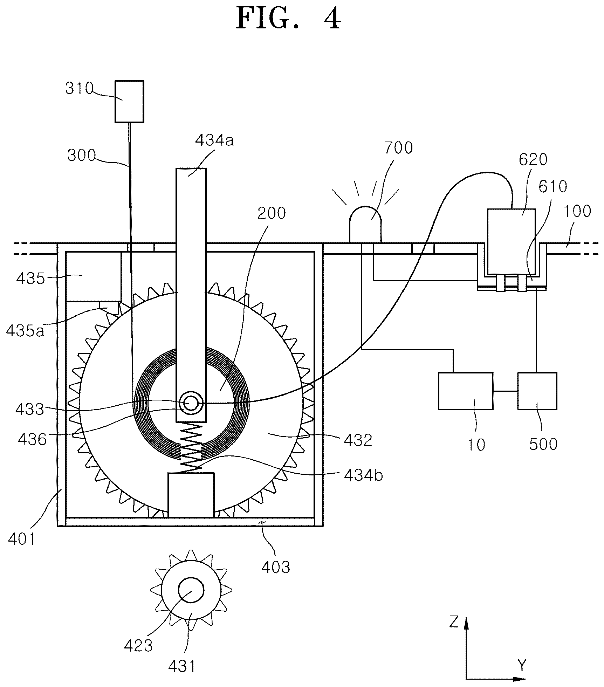

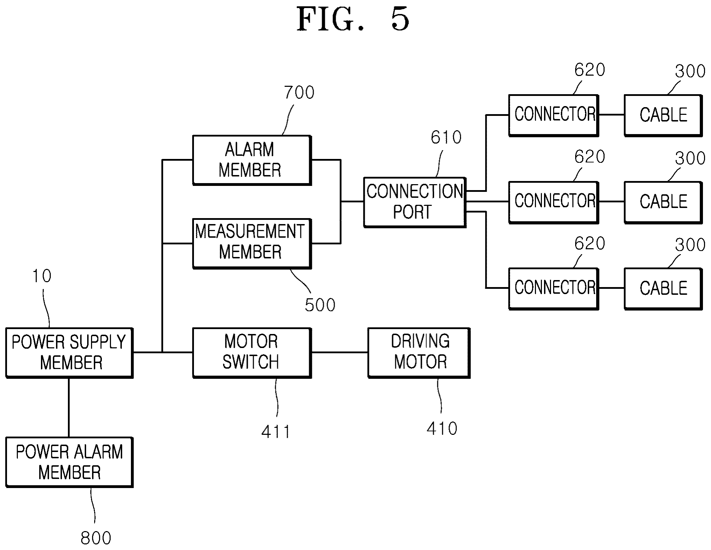

FIG. 2 is a schematic perspective view showing the secondary battery testing apparatus, FIG. 3 is a schematic front cross-sectional view showing the secondary battery testing apparatus, FIG. 4 is a schematic side cross-sectional view showing the secondary battery testing apparatus, and FIG. 5 is a schematic block diagram showing the secondary battery testing apparatus.

Referring to FIGS. 1 to 5, the secondary battery testing apparatus may include a case 100, a drum 200, a cable 300, an adjustment member 400, and a measurement member 500.

The case 100 may define an approximate exterior of the secondary battery testing apparatus 1 and provide a space in which the drum 200, the cable 300, the adjustment member 400, and the measurement member 500 may be accommodated.

The case 100 may have a hollow box geometry. The specific geometry of the case 100 may vary that may accommodate and support the drum 200, the cable 300, the adjustment member 400, the measurement member 500.

The drum 200 may be rotatably installed in the case 100.

The drum 200 may have a substantial cylindrical geometry. The drum 200 may be disposed in the case 100. The drum 200 may rotate clockwise and/or counterclockwise about a center axis in the case 100. The drum 200 may be rotatably supported in the case 100 by the adjustment member 400.

The drum 200 may be provided as a plurality of drums 200. The plurality of drums 200 may be spaced apart from each other or one another in the case 100. Each drum 200 may be independently rotatable in the case 100. The number of drums 200 is not limited to the number shown in FIGS. 3 and 4 and may vary.

The center axes of the drums 200 may be disposed in parallel or may be misaligned. As shown in FIGS. 2 and 3, the center axes of the plurality of drums 200 may be disposed parallel to an X-axis.

The cable 300 may transmit a detection signal to the measurement member 500 generated during the testing of a temperature or voltage of the secondary battery 22. The cable 300 may be wound around the drum 200. The cable 300 may be wound around the drum 200 or unwound from the drum 200 in conjunction with the rotational operation of the drum 200.

One end portion of the cable 300 may be disposed external to the case 100. The one end portion of the cable 300 may extend outward from the case 100 through a cable hole 101 passing through the case 100. The other end portion of the cable 300 may be connected to the drum 200. The other end portion of the cable 300 may be fixed to an outer surface of the drum 200.

The cable 300 may be wound around the drum 200 or unwound from the drum 200 relative to a rotation direction of the drum 200. For example, as shown in FIG. 4, as the drum 200 rotates in a forward direction (clockwise based on FIG. 4), the cable 300 may be unwound from the drum 200, and as the drum 200 rotates in a reverse direction (counterclockwise based on FIG. 4), the cable 300 may be wound around the drum 200.

Accordingly, the secondary battery testing apparatus 1 may adjust a length of one end portion of the cable 300 extending outward from the case 100 by the rotation operation of the drum 200.

The cable 300 may be a thermocouple cable that transmits a detection signal in the form of a current by a thermal electromotive force generated when heating or cooling a junction of metals of two types, to measure a temperature of the secondary battery 22. The cable 300 may be various metal cables that transmit a detection signal in the form of a current by an electromotive force generated by a potential difference between both end portions, to measure the voltage of the secondary battery 22.

A detection terminal 310 may be formed on one end portion of the cable 300 disposed external to the case 100. The detection terminal 310 may be formed of an electrically conductive material such as copper, nickel, or aluminum. The detection terminal 310 may be electrically connected to the cable 300. The detection terminal 310 may come into contact with an outer surface of the secondary battery 22 or the busbar 3. For example, when the cable 300 is a temperature measurement cable, the detection terminal 310 may come into contact with the outer surface of the secondary battery 22, and when the cable 300 is a voltage measurement cable, the detection terminal 310 may come into contact with the outer surface of the busbar 3.

The cable 300 may be provided as a plurality of cables 300. The number of cables 300 may be the same as the number of drums 200. The cables 300 may be wound one-to-one around different drums 200. Accordingly, a length of one end portion of each cable 300 extending outward from the case 100 may be independently adjusted by the rotation operations of the different drums 200. Each cable 300 may be one of the temperature measurement cable or the voltage measurement cable. The types of the plurality of cables 300 may be different or the same.

The adjustment member 400 may be connected to the drum 200 and may adjust the rotation of the drum 200.

The adjustment member 400 may include a driving motor 410, a first power transmission member 420, and a second power transmission member 430.

The driving motor 410 may generate a rotational force.

The driving motor 410 may be various types of electric motors having an output shaft capable of forward and reverse rotation. The driving motor 410 may be disposed in the case 100.

The forward rotational force generated by the driving motor 410 may be a rotational force for rotating the drum 200 in the forward direction (clockwise based on in FIG. 4) so that the cable 300 is unwound from the drum 200. The reverse rotational force generated by the driving motor 410 may be a rotational force for rotating the drum 200 in the reverse direction (counterclockwise based on in FIG. 4) so that the cable 300 is wound around the drum 200.

The reverse rotational force generated by the driving motor 410 may include a power supply member 10 for supplying power to the adjustment member 400, e.g., the driving motor 410.

The power supply member 10 may be a secondary battery capable of charging and discharging or a primary battery capable of discharging stored power. The power supply member 10 may be disposed in the case 100 or may be disposed external to the case 100. The power supply member 10 may be detachably coupled to the case 100. Accordingly, an operator can readily replace the power supply member 10 when the power supply member 10 is discharged. The power supply member 10 may be electrically connected to the driving motor 410 via a wire.

The secondary battery testing apparatus 1 may include a motor switch 411.

The motor switch 411 may be connected to the driving motor 410 and may control the operation of the driving motor 410.

The motor switch 411 may control the on/off operation of the driving motor 410 and the rotation direction of the driving motor 410 by a user. The motor switch 411 may be implemented in various forms such as a toggle switch, a button switch, or a touch panel, that may generate an electrical command signal by the user. The motor switch 411 may be disposed in the case 100. Alternatively, the motor switch 411 may be disposed outside the case 100 so that the user can readily access the motor switch 411. The motor switch 411 may be connected to the driving motor 410 in a wired or wireless manner. The motor switch 411 may transmit a command signal according to the user to the driving motor 410 in a wired or wireless manner.

The first power transmission member 420 may be rotated by receiving a rotational force from the driving motor 410.

The first power transmission member 420 may include a first transmission gear 421, a second transmission gear 422, and a first transmission shaft 423.

The first transmission gear 421 may be connected to the driving motor 410.

The first transmission gear 421 may be a cylindrical spur gear or pinion gear that has gear teeth on an outer surface thereof. The first transmission gear 421 may be connected to the output shaft of the driving motor 410. The output shaft of the driving motor 410 may pass through a central portion of the first transmission gear 421. An outer surface of the output shaft of the driving motor 410 may be spline-coupled to an inner surface of the first transmission gear 421. Accordingly, the first transmission gear 421 may rotate at the same angular velocity as the output shaft of the driving motor 410. The center axis of the first transmission gear 421 may be disposed parallel to the center axis of the drum 200.

The second transmission gear 422 may be spaced apart from the driving motor 410 and connected to the first transmission gear 421.

The second transmission gear 422 may be a cylindrical spur gear or pinion gear that has gear teeth on an outer surface thereof. A center axis of the second transmission gear 422 may be disposed parallel to the center axis of the first transmission gear 421. The second transmission gear 422 may engage with the first transmission gear 421. When the first transmission gear 421 rotates, the second transmission gear 422 may rotate in a direction opposite to a rotation direction of the first transmission gear 421.

In some embodiments, a gear ratio of the first transmission gear 421 and the second transmission gear 422 may ranges from 5:1 to 20:1. For example, a gear ratio of the first transmission gear 421 and the second transmission gear 422 may be 10:1. That is, when the first transmission gear 421 rotates 10 times, the second transmission gear 422 may rotate once. To this end, a diameter of the second transmission gear 422 may be greater than a diameter of the first transmission gear 421, and the number of gear teeth of the second transmission gear 422 may be 10 times the number of gear teeth of the first transmission gear 421.

A first transmission shaft 423 may rotate along with the second transmission gear 422.

The first transmission shaft 423 may have a rod shape disposed parallel to the center axis of the second transmission gear 422. A center axis of the first transmission shaft 423 may be positioned coaxially with the center axis of the second transmission gear 422. The first transmission shaft 423 may pass through a central portion of the second transmission gear 422. An outer surface of the first transmission shaft 423 may be spline-coupled to an inner surface of the second transmission gear 422. Accordingly, the first transmission shaft 423 may be rotated at the same angular velocity as the second transmission gear 422 when the second transmission gear 422 rotates.

Both end portions of the first transmission shaft 423 may be connected to an inner wall surface of the case 100 or a separate support part. Both of the end portions of the first transmission shaft 423 may be supported to rotate via a bearing.

The second power transmission member 430 may receive a rotational force from the first power transmission member 420 and rotate the drum 200. That is, the second power transmission member 430 may ultimately transmit the rotational force generated by the driving motor 410 to the drum 200.

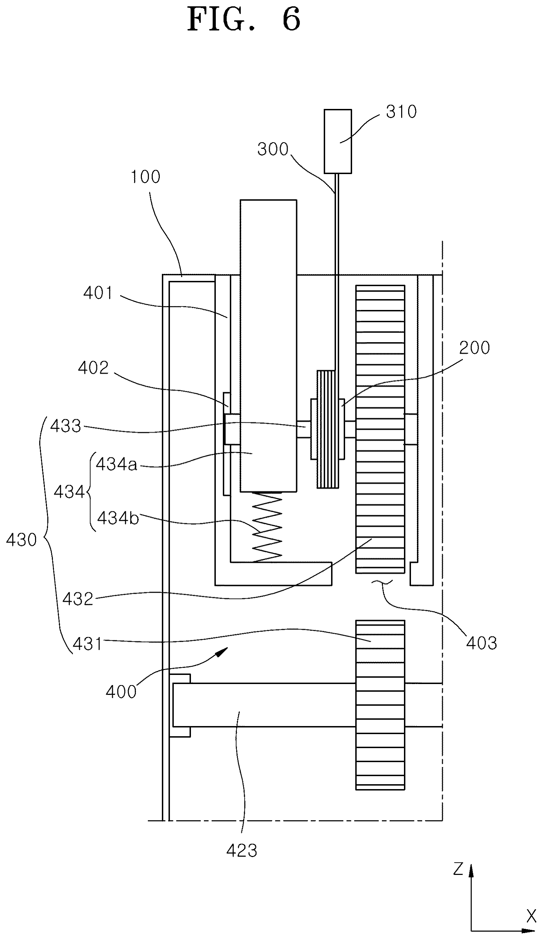

FIG. 6 is a schematic enlarged view showing the configuration of a second power transmitting member.

Referring to FIGS. 1 to 6, the second power transmission member 430 may include a third transmission gear 431, a fourth transmission gear 432, a second transmission shaft 433, and a trigger member 434.

The third transmission gear 431 may rotate along with the first transmission shaft 423.

The third transmission gear 431 may be a cylindrical spur gear or pinion gear that has gear teeth on an outer surface thereof. A center axis of the third transmission gear 431 may be disposed parallel to the center axes of the second transmission gear 422 and the first transmission shaft 423. The center axis of the third transmission gear 431 may be disposed coaxially with the center axes of the second transmission gear 422 and the first transmission shaft 423. The second transmission gear 422 and the third transmission gear 431 may be spaced apart from each other in a longitudinal direction of the first transmission shaft 423. The first transmission shaft 423 may pass through a central portion of the third transmission gear 431, and the outer surface of the first transmission shaft 423 may be spline-coupled to an inner surface of the third transmission gear 431.

The third transmission gear 431 may be provided as a plurality of third transmission gears 431. The number of plurality of third transmission gears 431 may be the same as the number of drums 200. The plurality of third transmission gears 431 may be arranged at set intervals in the longitudinal direction of the first transmission shaft 423.

The fourth transmission gear 432 may face the third transmission gear 431.

The fourth transmission gear 432 may be a cylindrical spur gear or pinion gear that has gear teeth on an outer surface thereof. A center axis of the fourth transmission gear 432 may be disposed parallel to the center axis of the third transmission gear 431. The center axis of the fourth transmission gear 432 may be disposed coaxially with the center axis of the drum 200.

The third transmission gear 431 and the fourth transmission gear 432 may face each other in a first direction. The third transmission gear 431 may be spaced apart from the fourth transmission gear 432 at an initial position.

The fourth transmission gear 432 may be rotated about the center axis in the case 100 and at the same time, may be linearly movable in the first direction and in a direction opposite to the first direction by the second transmission shaft 433. As the fourth transmission gear 432 moves in the first direction, the fourth transmission gear 432 may be engaged with the third transmission gear 431. As the fourth transmission gear 432 moves in the direction opposite to the first direction, the fourth transmission gear 432 may be separated from the third transmission gear 431. The first direction is a direction perpendicular to the center axis of the third transmission gear 431 and may be a direction parallel to a Z-axis based on FIGS. 3 and 4 and a direction from the fourth transmission gear 432 toward the third transmission gear 431.

As the third transmission gear 431 rotates while engaged with the fourth transmission gear 432, the fourth transmission gear 432 may rotate in a direction opposite to a rotation direction of the third transmission gear 431.

In some embodiments, a gear ratio of the third transmission gear 431 and the fourth transmission gear 432 may ranges from 5:1 to 20:1. For example, a gear ratio of the third transmission gear 431 and the fourth transmission gear 432 may be 10:1. That is, when the third transmission gear 431 rotates 10 times, the fourth transmission gear 432 may rotate once. To this end, a diameter of the fourth transmission gear 432 may be greater than a diameter of the third transmission gear 431, and the number of gear teeth of the fourth transmission gear 432 may be 10 times the number of gear teeth of the third transmission gear 431.

The fourth transmission gear 432 may be provided as a plurality of fourth transmission gears. The number of fourth transmission gears 432 may be the same as the number of third transmission gears 431. The fourth transmission gears 432 may individually face different third transmission gears 431 in the first direction.

The second transmission shaft 433 may connect the fourth transmission gear 432 to the drum 200. That is, the second transmission shaft 433 may transmit a rotational force of the fourth transmission gear 432 to the drum 200.

The second transmission shaft 433 may have a rod geometry disposed parallel to the center axis of the fourth transmission gear 432. The center axis of the second transmission shaft 433 may be disposed coaxially with the center axis of the fourth transmission gear 432 and the center axis of the drum 200. Both sides of the second transmission shaft 433 may pass individually through the central portions of the fourth transmission gear 432 and the drum 200.

An outer surface of the second transmission shaft 433 may be spline-coupled to an inner surface of the fourth transmission gear 432. Accordingly, when the fourth transmission gear 432 rotates, the second transmission shaft 433 may rotate at the same angular velocity as the fourth transmission gear 432.

The outer surface of the second transmission shaft 433 may be spline-coupled to an inner surface of the drum 200 or may come into frictional contact with the inner surface of the drum 200. Accordingly, when the fourth transmission gear 432 rotates, the drum 200 may rotate at the same angular velocity as the fourth transmission gear 432 along with the second transmission shaft 433.

The second transmission shaft 433 may be provided as a plurality of second transmission shafts. The number of second transmission shafts 433 may be the same as the number of fourth transmission gears 432. The second transmission shafts 433 may individually connect different fourth transmission gears 432 to drums 200.

Both end portions of the second transmission shaft 433 may individually protrude outward from the fourth transmission gear 432 and the drum 200. The second transmission shaft 433 may rotate about the center axis in the case 100 and at the same time, be linearly movable in the first direction and the direction opposite to the first direction.

The secondary battery testing apparatus 1 may include a guide body 401 that rotatably and movably supports the second transmission shaft 433.

The guide body 401 may be disposed in the case 100. The guide body 401 may have a hollow box geometry and may be fixed to the inner wall surface of the case 100.

The guide body 401 may be provided as a plurality of guide bodies. The number of guide bodies 401 may be the same as the number of drums 200. Each of the drum 200, the fourth transmission gear 432, and the second transmission shaft 433 may be disposed one-to-one in different guide bodies 401.

A guide rail 402 having a major axis parallel to the first direction may be disposed on the inner wall surface of the guide body 401. The guide rail 402 may have a groove geometry that is concavely formed from the inner wall surface of the guide body 401 or a hole geometry that passes through the guide body 401.

A guide hole 403 facing the fourth transmission gear 432 may be disposed on a bottom surface of the guide body 401. A cross-sectional area of the guide hole 403 perpendicular to the first direction may be greater than a cross-sectional area of the fourth transmission gear 432 perpendicular to the first direction. When the fourth transmission gear 432 moves in the first direction or in the direction opposite to the first direction, the fourth transmission gear 432 may enter and exit the interior and exterior of the guide body 401 through the guide hole 403.

Both end portions of the second transmission shaft 433 may be inserted into the guide rail 402. Both of the end portions of the second transmission shaft 433 may be rotated about the center axis of the second transmission shaft 433 in the guide rail 402. Both of the end portions of the second transmission shaft 433 may move in the first direction or in the direction opposite to the first direction parallel to a longitudinal direction of the guide rail 402 in the guide rail 402.

The trigger member 434 may be connected to the second transmission shaft 433. The trigger member 434 may control movement of the fourth transmission gear 432 and the second transmission shaft 433. That is, the trigger member 434 may move the fourth transmission gear 432 and the second transmission shaft 433 in the first direction and the direction opposite to the first direction.

The trigger member 434 may include a trigger body 434a and an elastic member 434b.

The trigger body 434a may be connected to the case 100 movable in the first direction and the direction opposite to the first direction.

The trigger body 434a may have a rod geometry where a longitudinal direction thereof is parallel to the first direction. One end portion of the trigger body 434a may pass through the case 100 and protrude outward from the case 100. As a user presses the one end portion of the trigger body 434a protruding outward from the case 100 in the first direction, the trigger body 434a may move in the first direction.

The other end portion of the trigger body 434a may be disposed in the case 100. The other end portion of the trigger body 434a may face the bottom surface of the guide body 401 in the first direction.

The trigger body 434a may be connected to the second transmission shaft 433. For example, the second transmission shaft 433 may pass through the other end portion of the trigger body 434a disposed in the case 100, and may be supported rotatably by the trigger body 434a. As the trigger body 434a moves in the first direction or in the direction opposite to the first direction, the second transmission shaft 433 may move along with the trigger body 434a in the first direction or in the direction opposite to the first direction, respectively.

The elastic member 434b may be connected to the trigger body 434a and may press the trigger body 434a in the direction opposite to the first direction.

The elastic member 434b may have various elastically deformable forms, such as a coil spring or an elastic pad, that may be expanded and contracted in the longitudinal direction. Both end portions of the elastic member 434b may be individually fixed to the other end portion of the trigger body 434a and the bottom surface of the guide body 401.

As the trigger body 434a moves in the first direction, the elastic member 434b may be compressively deformed and may accumulate an elastic force. As a pressing force applied to the one end portion of the trigger body 434a is removed, the elastic member 434b may press the trigger body 434a in the direction opposite to the first direction and move the trigger body 434a in the direction opposite to the first direction. Accordingly, when the user releases the pressing force applied on the trigger body 434a, the elastic member 434b may return the trigger body 434a to an initial position by its own elastic force.

The secondary battery testing apparatus 1 may include a brake member 435.

The brake member 435 may be fixed to the case 100 and may selectively restrict the rotation of the fourth transmission gear 432. Accordingly, the brake member 435 can prevent the drum 200 from being unnecessarily rotated due to the rotational inertia of the fourth transmission gear 432 after the fourth transmission gear 432 is separated from the third transmission gear 431.

The brake member 435 may spaced apart from the fourth transmission gear 432 in the direction opposite to the first direction. The brake member 435 may be fixed to the inner wall surface of the case 100.

The brake member 435 may include a stopper 435a that is engaged with the fourth transmission gear 432 when the fourth transmission gear 432 moves in the direction opposite to the first direction. As the brake member 435 is fixed to the inner wall surface of the case 100, the stopper 435a does not rotate along with the fourth transmission gear 432 and may stop the rotation of the fourth transmission gear 432. As the fourth transmission gear 432 moves in the first direction, the stopper 435a may be separated from the fourth transmission gear 432 and may allow the rotation of the fourth transmission gear 432. The specific geometry of the stopper 435a is not limited to the geometry shown in FIG. 4 and may be designed to have various geometry that may be engaged with the gear teeth formed on an outer surface of the fourth transmission gear 432.

The secondary battery testing apparatus 1 may include a friction member 436.

The friction member 436 may be disposed between the second transmission shaft 433 and the drum 200. When the secondary battery testing apparatus 1 includes the friction member 436, the outer surface of the second transmission shaft 433 may not be spline-coupled to the inner surface of the drum 200.

The friction member 436 may be disposed between the outer surface of the second transmission shaft 433 and the inner surface of the drum 200. An inner surface and outer surface of the friction member 436 may come into friction contact with the outer surface of the second transmission shaft 433 and the inner surface of the drum 200, respectively.

When a torque less than or equal to a set magnitude is applied between the second transmission shaft 433 and the drum 200, the drum 200 may be rotated at the same angular velocity as the second transmission shaft 433 by a frictional force of the friction member 436. A friction coefficient of the friction member 436 may be variously designed within the range in which the drum 200 may be rotated along with the second transmission shaft 433 when no external force other than the rotation of the fourth transmission gear 432 is applied between the second transmission shaft 433 and the drum 200.

When a torque greater than the set magnitude is applied between the second transmission shaft 433 and the drum 200, the drum 200 may be rotated relatively with respect to the second transmission shaft 433. Accordingly, when the rotation of the fourth transmission gear 432 and the second transmission shaft 433 is restricted by the brake member 435, an operator may manually rotate the drum 200 by directly pulling the cable 300.

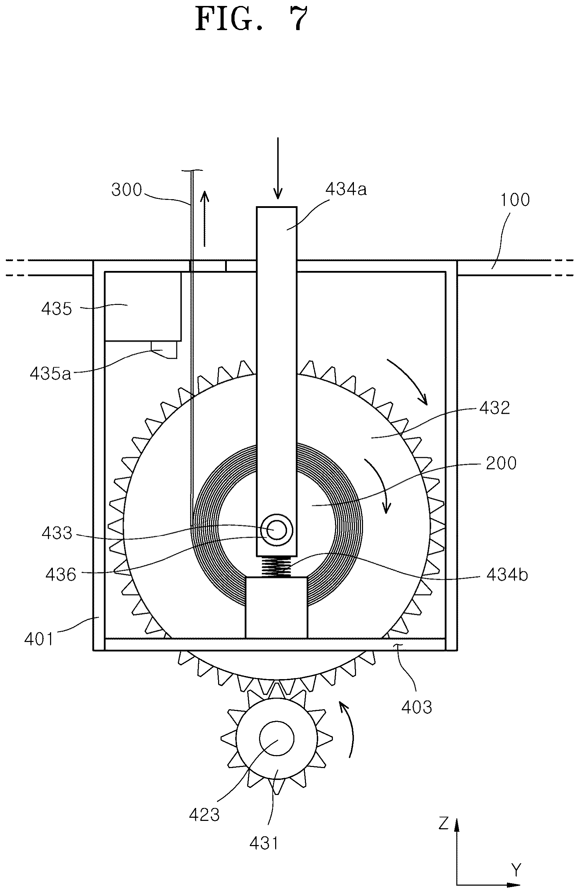

FIGS. 7 to 9 are schematic views showing an unwinding operation of a cable.

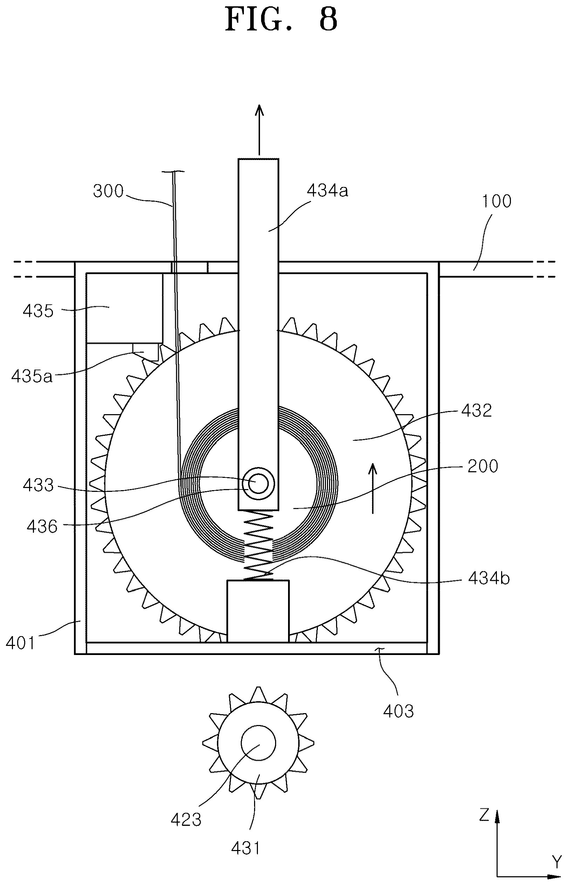

Referring to FIGS. 7 and 8, to increase a length of the cable 300 extending outward from the case 100, an operator presses the trigger body 434a in the first direction.

The trigger body 434a is moved in the first direction by a pressing force of the operator, and the second transmission shaft 433 and the fourth transmission gear 432 move in the first direction along with the trigger body 434a.

The fourth transmission gear 432 moves outward from the guide body 401 through the guide hole 403 and is engaged with the third transmission gear 431.
the operator manipulates the motor switch 411 so that the driving motor 410 generates a forward rotational force.

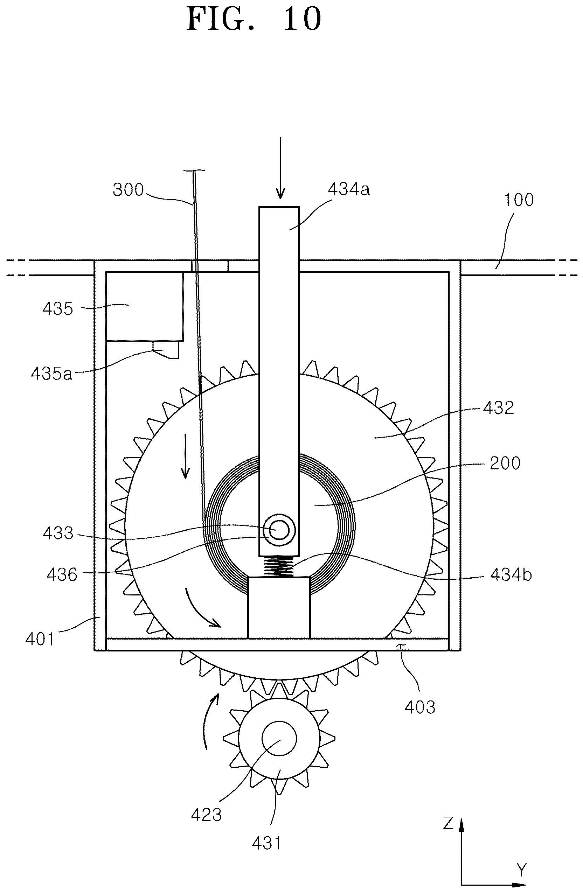

The forward rotational force of the driving motor 410 passes through the first transmission gear 421, the second transmission gear 422, and the first transmission shaft 423 and is transmitted to the third transmission gear 431, and the third transmission gear 431 rotates the fourth transmission gear 432 in the forward direction (clockwise based on FIG. 10).

As the fourth transmission gear 432 rotates in the forward direction, the drum 200 may rotate in the forward direction along with the second transmission shaft 433.

Accordingly, the cable 300 may be unwound from the drum 200, and the operator may pull the end portion of the cable 300 to increase the length of the cable 300 disposed outside the case 100.
as the operator releases the pressing force applied to the trigger body 434a, the trigger body 434a may move in the direction opposite to the first direction.

The second transmission shaft 433 and the fourth transmission gear 432 may move in the first direction along with the trigger body 434a, and the fourth transmission gear 432 may be separated from the third transmission gear 431.

As the fourth transmission gear 432 continuously moves in the direction opposite to the first direction, the fourth transmission gear 432 may be engaged with the stopper 435a of the brake member 435.

The rotation of the fourth transmission gear 432 is stopped by a fastening force with the stopper 435a, and the rotation of the second transmission shaft 433 and the drum 200 that are connected to the fourth transmission gear 432 may also be stopped.

Accordingly, after the unwinding operation of the cable 300, the constant length of the cable 300 disposed outside the case 100 can be maintained.

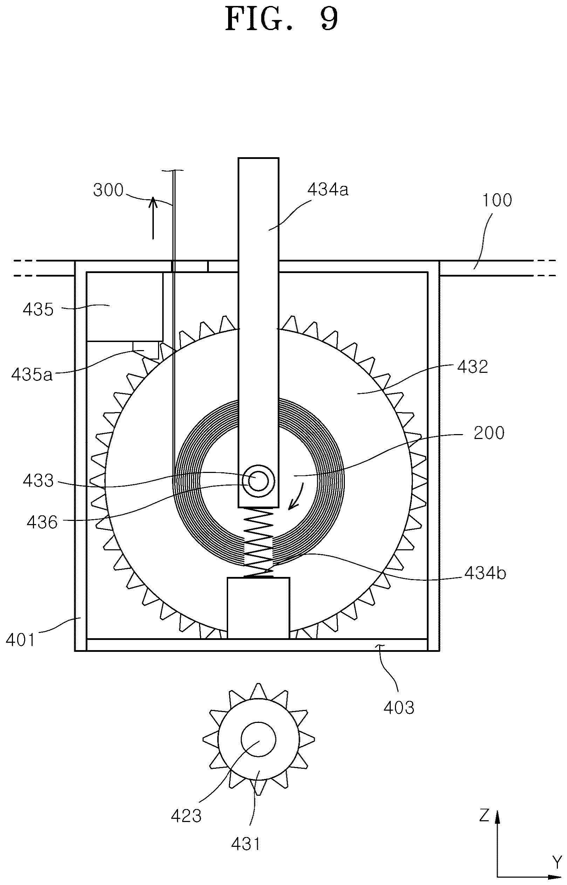

Referring to FIG. 9, when additional unwinding of the cable 300 is required when the fourth transmission gear 432 is engaged with the stopper 435a, the operator may manually pull the cable 300 disposed outside the case 100 to apply a tensile force to the cable 300.

As the tension applied to the cable 300 may be transmitted to the drum 200 and the rotation of the fourth transmission gear 432 and the second transmission shaft 433 is restricted by the stopper 435a, the torque acting between the drum 200 and the friction member 436 or the second transmission shaft 433 and the friction member 436 may be increased.

As the torque acting between the drum 200 and the friction member 436 exceeds the set magnitude, the drum 200 may rotate relatively with respect to the second transmission shaft 433 in the forward direction.

Accordingly, the cable 300 may be unwound from the drum 200 by the rotation of the drum 200, and the length of the cable 300 disposed outside the case 100 may be manually adjusted.

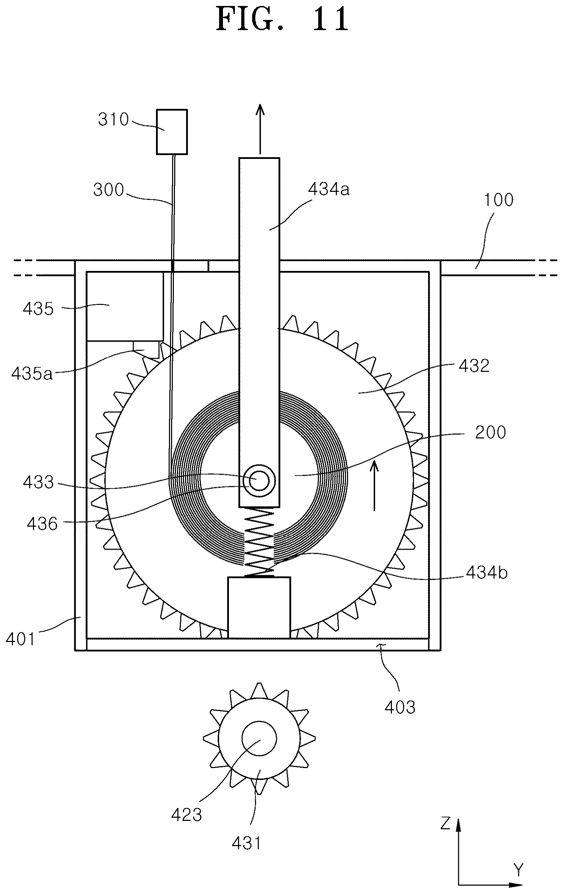

FIGS. 10 and 11 are schematic views showing a winding operation of the cable.

Referring to FIG. 10 and FIG. 11, in the case of rewinding of the cable 300 extending outward from the case 100, the operator presses the trigger body 434a in the first direction.

The trigger body 434a is moved in the first direction by a pressing force of the operator, and the second transmission shaft 433 and the fourth transmission gear 432 move in the first direction along with the trigger body 434a.

The fourth transmission gear 432 moves outward from the guide body 401 through the guide hole 403 and is engaged with the third transmission gear 431.

The operator manipulates the motor switch 411 so that the driving motor 410 generates a reverse rotational force.

The reverse rotational force of the driving motor 410 sequentially passes through the first transmission gear 421, the second transmission gear 422, and the first transmission shaft 423 and is transmitted to the third transmission gear 431, and the third transmission gear 431 rotates the fourth transmission gear 432 in the reverse direction (counterclockwise based on FIG. 7).

As the fourth transmission gear 432 rotates in the reverse direction, the drum 200 may rotate in the reverse direction along with the second transmission shaft 433.

Accordingly, the cable 300 may be wound around the drum 200, and the length of the cable 300 disposed outside the case 100 may be decreased.

After the cable 300 is sufficiently wound around the drum 200, the operator releases the pressing force applied to the trigger body 434a, and the trigger body 434a may move in the direction opposite to the first direction.

The second transmission shaft 433 and the fourth transmission gear 432 may move in the first direction along with the trigger body 434a, and the fourth transmission gear 432 may be separated from the third transmission gear 431.

As the fourth transmission gear 432 continuously moves in the direction opposite to the first direction, the fourth transmission gear 432 may be engaged with the stopper 435a of the brake member 435.

The rotation of the fourth transmission gear 432 is stopped by a fastening force with the stopper 435a, and the rotation of the second transmission shaft 433 and the drum 200 that are connected to the fourth transmission gear 432 may also be stopped.

Accordingly, after the winding operation of the cable 300, the constant length of the cable 300 disposed outside the case 100 can be maintained.

The measurement member 500 may be connected to the cable 300 and may measure the detection signal transmitted through the cable 300. For example, the measurement member 500 may receive the detection signal from the cable 300 and calculate a voltage or temperature of the secondary battery 22 based on the received detection signal.

To this end, the measurement member 500 may include at least one of an electronic control unit (ECU), a central processing unit (CPU), a processor, or a system on chip (SoC). The measurement member 500 may control a plurality of hardware or software components by driving an operating system or an application and perform various data processing and calculations. The measurement member 500 may be configured to execute at least one command stored in a memory and store execution result data in the memory. The measurement member 500 may include at least one of a radio frequency (RF), a Wi-Fi, a Bluetooth, a ZigBee, and a near field communication (NFC) device that may implement various communication protocols using which input signals generated by various input devices can be received.

The measurement member 500 may be connected to a plurality of cables 300 at the same time and may independently process the detection signals received from the cables 300. The measurement member 500 may be provided as a plurality of measurement members, and each measurement member 500 may be connected to a different cable 300.

The measurement member 500 may be disposed in the case 100 or may be installed separately external to the case 100.

The measurement member 500 may be electrically connected to the power supply member 10. The measurement member 500 may be connected to the power supply member 10 in a wired or wireless manner. The measurement member 500 may be operated by receiving power from the power supply member 10.

The secondary battery testing apparatus 1 may include a connection member 600 provided between the cable 300 and the measurement member 500 and connects the cable 300 to the measurement member *500.*

The connection member 600 may include a connection port 610 and a connector 620.

The connection port 610 may be connected to the measurement member 500.

The connection port 610 may have various types of connection terminals, such as an outlet or a Universal Serial Bus (USB) port, that may provide electrical connection between the measurement member 500 and an external electrical device. One side of the connection port 610 may be electrically connected to the measurement member 500 via a wire. The other side of the connection port 610 may be exposed to the outside of the case 100 to facilitate connection with the connector 620.

The connection port 610 may be provided as a plurality of connection ports. The number of connection ports 610 may be the same as the number of cables 300.

The connector 620 may be connected to the cable 300 and detachably coupled to the connection port 610.

One side of the connector 620 may have the form of a wire that may be electrically connected to the cable 300. The one side of the connector 620 may be installed not to interfere with the rotation operation of the drum 200. For example, the one side of the connector 620 may pass through the central portion of the second transmission shaft 433 and the drum 200 and may be directly connected to the end portion of the cable 300 fixed to the outer surface of the drum 200. The one side of the connector 620 may be connected to the guide body 401 or the like and may be indirectly connected to the cable 300 through the drum 200, the second transmission shaft 433, and the guide body 401. The drum 200, the second transmission shaft 433, and the guide body 401 may be formed of an electrically conductive material.

The other side of the connector 620 may have various forms, such as a plug or a connection pin, that may be mechanically and electrically connected to the other side of the connection port 610 exposed to the outside of the case 100. The other side of the connector 620 may be detachably coupled to the connection port 610. When the other side of the connector 620 is coupled to the connection port 610, the connector 620 and the connection port 610 may electrically connect the cable 300 to the measurement member 500. When the other side of the connector 620 is separated from the connection port 610, the connector 620 and the connection port 610 may block the electrical connection between the cable 300 and the measurement member 500.

The connector 620 may be provided as a plurality of connectors 620. The number of connectors 620 may be the same as the number of connection ports 610. The connectors 620 may be individually connected to different cables 300. Each connector 620 may be detachably coupled to a different connection port 610.

Accordingly, an operator can prevent unnecessary data from being inputted to the measurement member 500 by blocking the electrical connection between the cable 300 and the measurement member 500 in which a voltage or temperature measurement operation is not performed on the secondary battery 22. When the cable 300 is damaged, only the damaged cable 300 can be replaced without replacing the entire equipment, thereby enabling efficient management.

The secondary battery testing apparatus 1 may include an alarm member 700.

The alarm member 700 may be connected to the cable 300 and may detect disconnection of the cable 300.

The alarm member 700 may include at least one of a lamp turned on when a current is applied or a speaker that outputs a voice signal. Both sides of the alarm member 700 may each be electrically connected to one of the connection port 610 and the power supply member 10. As the connector 620 is coupled to the connection port 610, the power supply member 10, the cable 300, and the alarm member 700 may form a closed circuit through the connection port 610 and the connector 620. When disconnection does not occur in the cable 300, the alarm member 700 may output light or a voice signal by the current supplied from the power supply member 10. When the disconnection occurs in the cable 300, the alarm member 700 may not output light or a voice signal due to a circuit being opened. Accordingly, the operator can readily identify the disconnected state of the cable 300 through the alarm member 700.

The alarm member 700 may be provided as a plurality of alarm members 700. The number of alarm members 700 may be formed to be the same as the number of cables 300. One side of each alarm member 700 may be connected to a different connection port 610. Accordingly, each alarm member 700 may detect the disconnected state of the different cable 300.

The secondary battery testing apparatus 1 may include a power alarm member 800.

The power alarm member 800 may be connected to the power supply member 10 and may detect the charging state of the power supply member 10.

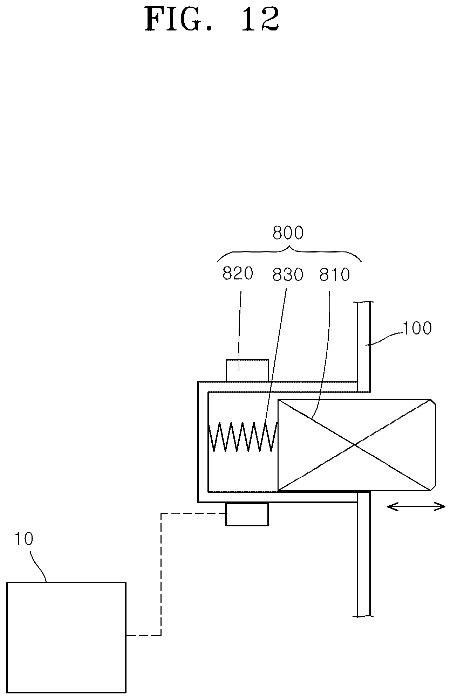

FIG. 12 is a schematic enlarged view showing a power alarm member.

Referring to FIG. 12, the power alarm member 800 may include a plunger 810, a solenoid coil 820, and a spring 830.

The plunger 810 may be reciprocally connected to the case 100. An end portion of the plunger 810 may be exposed to an external space of the case 100. As the plunger 810 moves outward from the case 100, the end portion of the plunger 810 may protrude outward from the case 100. As the plunger 810 moves inward from the case 100, the end portion of the plunger 810 may be disposed in the case 100 without protruding outward from the case 100.

The solenoid coil 820 may be connected to the power supply member 10 and may generate a magnetic force by receiving power from the power supply member 10. The solenoid coil 820 may be disposed to surround a perimetric surface of the plunger 810. The solenoid coil 820 may generate a magnetic force in the direction in which the plunger 810 moves inward from the case 100. A strength of the magnetic force generated by the solenoid coil 820 may increase or decrease in proportion to a voltage according to the charge amount of the power supply member 10.

The spring 830 may be disposed between the plunger 810 and the case 100. The spring 830 may have the form of a coil spring that may be expanded or contracted in the longitudinal direction. The spring 830 may press the plunger 810 in the direction in which the plunger 810 moves outward from the case 100, that is, in the direction opposite to the magnetic force generated by the solenoid coil 820.

When the voltage of the power supply member 10 is greater than a set voltage, the magnitude of the magnetic force generated by the solenoid coil 820 may be greater than the magnitude of an elastic force applied to the plunger 810 by the spring 830. Accordingly, the plunger 810 may be maintained while disposed in the case 100 during the normal operation of the power supply member 10.

When the voltage of the power supply member 10 is less than the set voltage, the magnitude of the magnetic force generated by the solenoid coil 820 may be less than the magnitude of the elastic force applied to the plunger 810 by the spring 830. Accordingly, when the power supply member 10 is discharged or the power supply member 10 may not supply a sufficient voltage to the adjustment member 400 or the measurement member 500, the plunger 810 may protrude outward from the case 100. Accordingly, the user can readily identify a current charging state of the power supply member 10 by determining whether the plunger 810 protrudes.

The set voltage of the power supply member 10 may be variously designed within the range between the normal voltage of the power supply member 10 and a discharging voltage thereof.

According to the present disclosure, because a length of a cable extending outward from a case can be adjusted by the rotation of a drum, the cable can be easily managed, and damage to the cable due to cable tangling can be prevented.

According to the present disclosure, because winding and unwinding operations of the cable can be automatically performed by an adjustment member, it is possible to improve convenience of the work.

According to the present disclosure, because a disconnection state of the cable or a charging state of power, can be readily identified, it is possible to secure reliability of the work.

However, the effects obtainable through the present disclosure are not limited to the above effects, and other technical effects that are not mentioned will be clearly understood by those skilled in the art from the following description of the present disclosure.

While the present disclosure has been described with reference to embodiments shown in the drawings, these embodiments are merely illustrative and it should be understood that various modifications and equivalent other embodiments can be derived by those skilled in the art on the basis of the embodiments.

## Claims

1. A secondary battery testing apparatus (1) comprising:
a case (100);
a drum (200) rotatably disposed in the case (100);
a cable (300) configured to be wound around the drum (200) and having a detection terminal (310) extending outward from the case (100);
an adjustment member (400) connected to the drum (200) and configured to adjust rotation of the drum (200); and
a measurement member (500) connected to the cable (300) and configured to measure a detection signal transmitted through the cable (300).

2. The secondary battery testing apparatus (1) as claimed in claim 1, comprising a plurality of drums (200) and a plurality of cables (300), wherein each of the cables (300) is configured to be wound one-to-one around each of the drums (200).

3. The secondary battery testing apparatus (1) as claimed in claim 1 or 2, wherein the adjustment member (400) comprises:
a driving motor (410) configured to generate a rotational force;
a first power transmission member (420) configured to be rotated by receiving the rotational force from the driving motor (410); and
a second power transmission member (430) configured to receive a rotational force from the first power transmission member (420) and configured to rotate the drum (200).

4. The secondary battery testing apparatus (1) as claimed in claim 3, wherein the adjustment member (400) further comprises a motor switch (411) connected to the driving motor (410) and configured to control operation of the driving motor (410).

5. The secondary battery testing apparatus (1) as claimed in claim 3 or 4, wherein the first power transmission member (420) comprises:
a first transmission gear (421) connected to the driving motor (410);
a second transmission gear (422) spaced apart from the driving motor (410) and connected to the first transmission gear (421); and
a first transmission shaft (423) configured to rotate along with the second transmission gear (422).

6. The secondary battery testing apparatus (1) as claimed in claim 5, wherein the second power transmission member (430) comprises:
a third transmission gear (431) configured to rotate along with the first transmission shaft (423);
a fourth transmission gear (432) facing the third transmission gear (431) and configured to move in a first direction engaging the third transmission gear (431);
a second transmission shaft (433) extending from the fourth transmission gear (432) and is connected to the drum (200); and
a trigger member (434) connected to the second transmission shaft (433) and configured to adjust movement of the fourth transmission gear (432) and the second transmission shaft (433).

7. The secondary battery testing apparatus (1) as claimed in claim 6, wherein the second transmission shaft (433) passes through a central portion of the drum (200).

8. The secondary battery testing apparatus (1) as claimed in claim 6 or 7, wherein the trigger member (434) comprises:
a trigger body (434a) movably connected to the case (100) in the first direction or in a direction opposite to the first direction and configured to rotatably support the second transmission shaft (433); and
an elastic member (434b) connected to the trigger body (434a) and configured to press the trigger body (434a) in the direction opposite to the first direction.

9. The secondary battery testing apparatus (1) as claimed in any one of claims 6 to 8, further comprising a guide body (401) disposed in the case (100) and configured to rotatably and movably support the second transmission shaft (433).

10. The secondary battery testing apparatus (1) as claimed in any one of claims 6 to 9, further comprising a brake member (435) fixed to the case (100) and configured to selectively restrict rotation of the fourth transmission gear (432).

11. The secondary battery testing apparatus (1) as claimed in claim 10, wherein the brake member (435) comprises a stopper (435a) engaging the fourth transmission gear (432) when the fourth transmission gear (432) moves in a direction opposite to the first direction.

12. The secondary battery testing apparatus (1) as claimed in claim 10, wherein the second power transmission member (430) further comprises a friction member (436) disposed between the second transmission shaft (433) and the drum (200).

13. The secondary battery testing apparatus (1) as claimed in any one of claims 1 to 12, further comprising a connection member (600) connecting the cable (300) to the measurement member (500).

14. The secondary battery testing apparatus (1) as claimed in any one of claims 1 to 13, further comprising an alarm member (700) connected to the cable (300) and configured to detect disconnection of the cable (300).

15. The secondary battery testing apparatus (1) as claimed in any one of claims 1 to 14, further comprising a power supply member configured to supply power to the adjustment member (400) and the measurement member (500).
